(19) Europäisches Patentamt
European Patent Office
Office européen des brevets

(11) **EP 2 904 685 B1**

(12) **FASCICULE DE BREVET EUROPEEN**

(45) Date de publication et mention
de la délivrance du brevet:
**30.08.2017 Bulletin 2017/35**

(21) Numéro de dépôt: **13785516.9**

(22) Date de dépôt: **01.10.2013**

(51) Int Cl.:
***H02J 3/38*** $^{(2006.01)}$

(86) Numéro de dépôt international:
**PCT/FR2013/052331**

(87) Numéro de publication internationale:
**WO 2014/053763 (10.04.2014 Gazette 2014/15)**

(54) **DETECTION D'ILOTAGE D'UN ONDULEUR**

ERKENNUNG VON LASTABWURF EINES WECHSELRICHTERS

DETECTION OF LOAD-SHEDDING OF AN INVERTER

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **01.10.2012 FR 1259245**

(43) Date de publication de la demande:
**12.08.2015 Bulletin 2015/33**

(73) Titulaire: **Commissariat à l'Énergie Atomique
et aux Énergies Alternatives
75015 Paris (FR)**

(72) Inventeur: **TRAN, Quoc-Tuan
38610 Gieres (FR)**

(74) Mandataire: **Thibon, Laurent
Cabinet Beaumont
1, rue Champollion
38000 Grenoble (FR)**

(56) Documents cités:
**EP-A1- 1 764 894        US-A1- 2006 082 936
US-A1- 2009 319 093**

- **VIVEK MENON ET AL: "A Hybrid Islanding
Detection Technique Using Voltage Unbalance
and Frequency Set Point", IEEE TRANSACTIONS
ON POWER SYSTEMS, IEEE SERVICE CENTER,
PISCATAWAY, NJ, US, vol. 22, no. 1, 1 février 2007
(2007-02-01), pages 442-448, XP011161642, ISSN:
0885-8950**

**Description**

Domaine de l'invention

La présente invention concerne de façon générale les réseaux de distribution électrique et, plus particulièrement, l'îlotage d'une unité de production décentralisée, raccordée à un réseau de distribution électrique.

Exposé de l'art antérieur

Un réseau de distribution électrique comporte de plus en plus souvent des unités décentralisées de production d'énergie. Outre les traditionnelles centrales thermiques, nucléaires ou hydrauliques, de plus en plus d'unités décentralisées (le plus souvent photovoltaïques ou éoliennes) de production de faible puissance sont connectées au réseau. Typiquement, des habitations ou industries sont équipées de panneaux photovoltaïques dont l'énergie produite est réinjectée, par le biais d'un onduleur, sur le réseau de distribution électrique. Ces unités de production, dites décentralisées, se trouvent connectées au réseau dit basse-tension qui alimente les habitations et petites industries, c'est-à-dire en aval de transformateurs moyenne ou haute tension vers basse tension. Ces onduleurs ou autres dispositifs raccordant l'unité au réseau se retrouvent alors en parallèle avec la connexion des charges alimentées par le réseau.

Les références de phase et de tension des onduleurs sont fournies par le réseau de distribution. Par conséquent, si le réseau vient à être déconnecté de la zone de l'onduleur, celui-ci se trouve dans une situation, dite d'îlotage, où il est isolé du réseau. Cela peut se produire accidentellement ou volontairement, par exemple lors d'opérations de maintenance du réseau. On doit alors procéder à un arrêt de l'onduleur de façon à éviter que l'énergie qu'il produit continue à être injectée sur la partie du réseau en aval de la déconnection. En effet, cela présente des risques pour le matériel qui est susceptible d'être endommagé notamment lorsque la tension du réseau est réinjectée, et pour les personnes qui procèdent à la maintenance sur la partie du réseau qu'elles croient déconnectée.

Il faut donc être capable de détecter une situation d'îlotage pour pouvoir éteindre l'onduleur. En fait, il convient de réduire au maximum le temps de fonctionnement du système isolé afin d'éviter d'alimenter un défaut ou de laisser sous tension une installation en défaut, d'éviter d'alimenter l'îlot à une tension ou à une fréquence anormale, de permettre à des systèmes de réarmement automatique de fonctionner correctement, de protéger les personnes à proximité des équipements, etc.

Les méthodes de détection d'îlotage sont réparties en trois catégories.

Les méthodes dites à communication requièrent une communication directe entre le réseau (plus précisément une centrale de commande du réseau) et l'unité décentralisée. Par exemple, une liaison de transmission de données permet au réseau d'informer l'unité décentralisée de la situation d'îlotage. De telles méthodes sont très onéreuses et difficilement adaptables à des unités existantes, sauf à prévoir des moyens de communication sans fil, ce qui accroît encore le coût.

Les méthodes dites actives consistent à détecter un évènement placé volontairement sur le réseau. Par exemple, dans une situation d'îlotage, le réseau émet des impulsions perturbatrices susceptibles d'être détectées côté onduleur. De telles méthodes requièrent une action côté réseau (pouvoir générer des perturbations). De plus, des impulsions accidentelles peuvent engendrer des fausses détections.

Les méthodes dites passives auxquelles s'applique la présente invention se bornent à exploiter des mesures faites côté unité décentralisée. Les méthodes passives actuelles souffrent de zones de non-détection importantes liées aux marges qui doivent être prises afin d'éviter des déclenchements intempestifs.

Le document XP011161642, intitulé "A Hybrid Islanding Détection Technique Using Voltage Unbalance and Frequency Set Point" de VIVEK MENON ET AL divulgue un procédé de détection hybride d'îlotage d'un onduleur connecté à un réseau de distribution électrique mêlant une méthode active dite de retour positif (positive feedback) et une méthode passive basée sur le taux de déséquilibre de tension entre phases fournie par l'onduleur.

Résumé

Un objet d'un mode de réalisation de la présente invention est de pallier tout ou partie des inconvénients des techniques connues de détection d'îlotage.

Un autre objet d'un mode de réalisation de la présente invention est de proposer une solution passive.

Un autre objet d'un mode de réalisation de la présente invention est de proposer une solution qui ne perturbe pas le réseau.

Un autre objet d'un mode de réalisation de la présente invention est de proposer une solution qui ne nécessite pas d'équipement additionnel dans les onduleurs existants et qui soit aisée à implanter dans ces onduleurs.

Pour atteindre tout ou partie de ces objets ainsi que d'autres, un mode de réalisation prévoit un procédé de détection d'îlotage d'un onduleur connecté à un réseau de distribution électrique, comportant au moins des étapes de :

    détermination de la dérivée temporelle du taux de déséquilibre de tension entre phases fournie par l'onduleur ;
    détermination de la dérivée temporelle de la fréquence de la tension fournie par l'onduleur ;
    multiplication des deux valeurs ; et
    comparaison à un seuil.

Selon un mode de réalisation de la présente invention, le procédé comporte en outre des étapes de :

détermination de la dérivée temporelle de la charge réactive de l'onduleur ; et
prise en compte de cette valeur dans l'étape de multiplication.

Selon un mode de réalisation de la présente invention, l'onduleur fournit une tension triphasée.
Selon un mode de réalisation de la présente invention, le procédé comporte en outre une étape de fourniture d'un signal de commande à l'onduleur.
Selon un mode de réalisation de la présente invention, l'onduleur est associé à des panneaux photovoltaïques.
On prévoit également un dispositif de détection d'îlotage adapté à la mise en oeuvre du procédé ci-dessus.
Selon un mode de réalisation de la présente invention, le dispositif comporte au moins un capteur de tension connecté en sortie de l'onduleur.
Selon un mode de réalisation de la présente invention, le dispositif comporte en outre un capteur de charge réactive.
Selon un mode de réalisation de la présente invention, le dispositif comporte des moyens de calcul desdites dérivées.
On prévoit également une centrale solaire comportant :

au moins un panneau photovoltaïque ;
au moins un onduleur ; et
un dispositif de détection d'îlotage.

Brève description des dessins

Ces objets, caractéristiques et avantages, ainsi que d'autres seront exposés en détail dans la description suivante de modes de réalisation particuliers faite à titre non limitatif en relation avec les figures jointes parmi lesquelles :

la figure 1 est une représentation très schématique et partielle d'un réseau électrique auquel s'appliquent les modes de réalisation qui vont être décrits ;
la figure 2 illustre la connexion d'un équipement de production d'énergie décentralisé à un réseau ;
la figure 3 illustre un mode de réalisation d'un dispositif de détection d'îlotage ;
la figure 4 illustre un autre mode de réalisation d'un dispositif de détection d'îlotage ; et
les figures 5A, 5B, 5C, 5D, 5E, 5F, 5G et 5H sont des chronogrammes illustrant le fonctionnement des modes de réalisation des figures 3 et 4.

Description détaillée

De mêmes éléments ont été désignés par de mêmes références aux différentes figures. Par souci de clarté, seuls les étapes et éléments utiles à la compréhension des modes de réalisation décrits ont été représentés et seront décrits. En particulier, les unités de production décentralisées et les onduleurs ou dispositifs analogues n'ont pas été détaillés, les modes de réalisation décrits étant compatibles avec les unités et dispositifs usuels. De plus, la constitution du réseau de distribution n'a pas non plus été détaillée, les modes de réalisation étant compatibles avec tout réseau usuel de distribution triphasé.

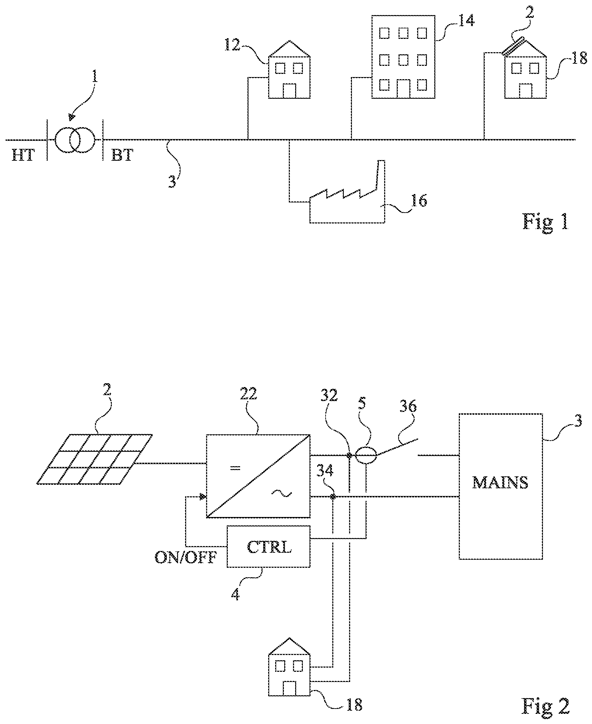

La figure 1 représente, de façon très schématique et simplifiée, un exemple de réseau 3 de distribution électrique en aval d'un transformateur 1 ramenant une haute tension HT (typiquement plusieurs dizaines de kilovolts) à une basse tension BT destinée à alimenter des installations d'abonnés. La basse tension est par exemple de 220 volts (entre phase et neutre) ou 380 volts (entre phases). Les diverses installations alimentées par le réseau électrique peuvent être des habitations individuelles 12, des habitations collectives 14, des ateliers ou industries 16. D'autres installations peuvent être directement connectées au réseau moyenne ou haute tension (industrie lourde, transport ferroviaire, par exemple), mais sont alors situées en amont du transformateur 1. On se préoccupe ici d'installations raccordées à un réseau basse tension.
De plus en plus souvent, des installations (dans l'exemple de la figure 1, une habitation 18) sont équipées d'unités de production d'énergie (par exemple solaire ou éolienne). Il s'agit, par exemple, de panneaux photovoltaïques 2 qui sont raccordés, par l'intermédiaire d'un onduleur (non visible en figure 1) aux câbles du réseau de distribution 3, et injectent de l'énergie sur ce réseau.
La figure 2 est une représentation schématique d'un système de raccordement d'une unité de production décentralisée 2 à un réseau de distribution électrique 3 (MAINS). Typiquement, s'agissant de panneaux photovoltaïques, ceux-ci convertissent l'énergie solaire qu'ils reçoivent en un courant continu qui est traité par un onduleur 22. Le rôle de l'onduleur est de transformer le courant continu en un courant alternatif apte à être injecté sur le réseau. Pour cela, l'onduleur doit recevoir du réseau des informations sur la phase et sur le niveau de tension du signal alternatif. L'onduleur 22 est en parallèle sur le réseau, c'est-à-dire qu'une charge (par exemple, les équipements de la maison 18 portant les panneaux solaires) est connectée à des bornes d'alimentation 32 et 34 communes au réseau 3 et à l'onduleur. Dans les applications visées par les modes de réalisation qui vont être décrits, l'onduleur est triphasé. La charge 18 peut cependant être en triphasé ou en monophasé.
En situation d'îlotage (symbolisée en figure 2 par un interrupteur 36 à l'état ouvert entre la borne 32 et le réseau 3) accidentel ou volontaire, on doit pouvoir arrêter (mettre hors service) l'onduleur 22. A défaut, les équipements électriques connectés en aval de l'interrupteur 36 (ou de la rupture accidentelle du câble) restent alimentés par l'onduleur. Cela est dangereux pour les personnes et est préjudiciable aux équipements dans la mesure où l'information de phase est perdue. Par exemple, cela peut poser problème lorsque le réseau est de nouveau connecté. De plus, cela nuit au fonctionnement des équipements détectant une perte d'alimentation et possédant une fonction de réarmement automatique quand la tension réapparait.

On prévoit donc un détecteur d'îlotage 4 (CTRL) pour commander un arrêt de l'onduleur 22 en cas de situation d'îlotage. Dans le cas d'un détecteur passif, on exploite des mesures (capteur 5) de différentes grandeurs en sortie de l'onduleur 22. De préférence, le ou les capteurs 5 sont placés au plus près de (la sortie de) l'onduleur 22.

Le besoin de garantir un îlotage rapide des onduleurs associés à des unités de production d'énergie décentralisées est de plus en plus présent avec la multiplication des mini-centrales qui accroit considérablement le nombre de sources de problèmes potentiels.

Les modes de réalisation qui vont être décrits concernent des méthodes passives, c'est-à-dire qui ne requièrent ni injection de perturbations au réseau lorsque celui-ci fonctionne, ni communication entre l'onduleur et le réseau.

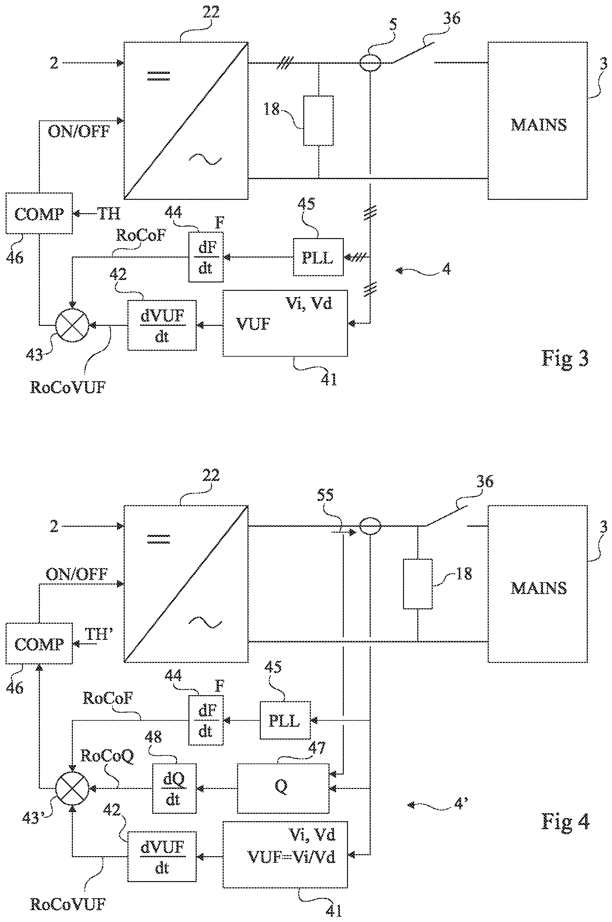

La figure 3 représente, de façon très schématique et sous forme de blocs, un mode de réalisation d'un dispositif 4 de détection d'îlotage. Ce dispositif exploite des mesures des tensions présentes sur les différentes phases de la tension triphasée fournie par l'onduleur 22. Le capteur 5 fournit donc trois informations.

On prévoit d'exploiter la dérivée du taux de déséquilibre de tension (RoCoVUF - Rate of Change of Voltage Unbalance Factor) de l'onduleur et de le pondérer par la dérivée de la fréquence (RoCoF - Rate of Change of Frequency).

Le taux de déséquilibre de tension VUF correspond, dans un réseau triphasé, au rapport de la tension inverse Vi sur la tension directe Vd. Pour mémoire, la tension directe correspond à la moyenne complexe des trois phases prises dans l'ordre (passant par zéro successivement) et la tension inverse correspond à la moyenne complexe des trois phases dans un ordre différent.

Le calcul de la valeur VUF est connu et donne une valeur en pourcents correspondant à la relation suivante :

$$VUF = Vi/Vd,$$

avec

$$Vi = \frac{V_{ab} + a.V_{bc} + a^2.V_{ca}}{3},$$

et

$$Vd = \frac{V_{ab} + a^2.V_{bc} + a.V_{ca}}{3},$$

où

$V_{ab}$, $V_{bc}$ et $V_{ca}$ désignent les tensions entre phases et $a = e^{j\frac{2\pi}{3}}$ représente l'angle entre phases.

Le taux VUF, fourni par un bloc 41, est traité pour en obtenir la dérivée temporelle. On calcule donc (bloc 42, dVUF/dt) la dérivée du taux VUF pour obtenir la valeur RoCoVUF. On obtient alors une indication sur les variations rapides de tension.

Le fait de surveiller le taux de déséquilibre de tension (VUF) de l'onduleur 22 permet de détecter certaines conditions d'îlotage. Lorsque le réseau 3 est connecté à l'onduleur 22, la valeur du VUF est faible (typiquement inférieure à 2%). Toutefois, en situation d'îlotage, l'impédance de la charge 18 est souvent plus élevée que celle du réseau et la charge locale est rarement équilibrée, ce qui provoque une hausse du VUF. En effet, lorsque l'onduleur est connecté au réseau, statistiquement, la consommation des différentes phases est relativement équilibrée, ce qui est difficilement le cas pour une charge locale.

Cette valeur RoCoVUF est pondérée (multipliée par un multiplieur 43) par une valeur représentant la dérivée temporelle de la fréquence RoCoF. Cette valeur RoCoF est obtenue en calculant (bloc 44, dF/dt) la dérivée de la fréquence de la tension. Cette dérivée est obtenue, par exemple, à partir d'une boucle à verrouillage de phase (bloc 45, PLL). L'information sur la dérivée de la fréquence donne une indication sur les variations rapides de fréquence.

On aurait pu penser combiner la dérivée de la fréquence RoCoF avec la dérivée de la tension (valeur connue sous l'acronyme RoCoV - Rate of Change of Voltage). Toutefois, un avantage d'utiliser la dérivée du taux de déséquilibre de tension entre phases est que cette valeur est indépendante des valeurs de la fréquence et de la tension elles-mêmes. Ainsi, on évite de fausses détections en cas de variations brutales de charge ou de production du réseau qui ne correspondent pas à une situation d'îlotage.

Le produit RoCoF par RoCoVUF fourni par le multiplieur 43, est comparé (bloc 46, COMP) à un seuil TH pour fournir un signal autorisant l'allumage (ON) ou forçant l'extinction (OFF) de l'onduleur 22.

La figure 4 représente un autre mode de réalisation selon lequel on prend également en compte la dérivée de la puissance réactive de l'onduleur. Pour cela, on exploite une mesure (capteur 55) du courant fourni par l'onduleur. Cette mesure est exploitée avec la tension pour calculer la puissance réactive (bloc 47 - Q) et on en déduit la dérivée temporelle (bloc 48, dQ/dt). On obtient alors la dérivée temporelle de la puissance réactive Ro-CoQ (Rate of Change of Reactive Power Output). Cette valeur est multipliée (multiplieur 43') par les valeurs Ro-CoF et RoCoVUF du mode de réalisation précédent (figure 3). Le résultat est comparé à un seuil TH' pour, si besoin, déconnecter l'onduleur.

Les techniques de calcul de puissance réactive sont en elles-mêmes connues. Il existe même des capteurs directs de puissance réactive.

L'exploitation de la dérivée de la puissance réactive est un complément au mode de réalisation de la figure 3. En effet, cette mesure ne suffit pas à elle seule, car l'onduleur peut fournir lui-même une puissance réactive qui engendrerait une erreur de détection.

La multiplication des différentes valeurs permet d'amplifier les variations en présence d'un réel îlotage et d'amoindrir une variation d'un seul des paramètres qui résulterait d'une autre situation que l'îlotage. Par exemple, en cas de fonctionnement normal, la dérivée de la fréquence RoCoF est quasiment nulle. Ainsi, même avec un taux de déséquilibre très élevé de la tension ou une forte variation de puissance réactive, le produit restera proche de 0.

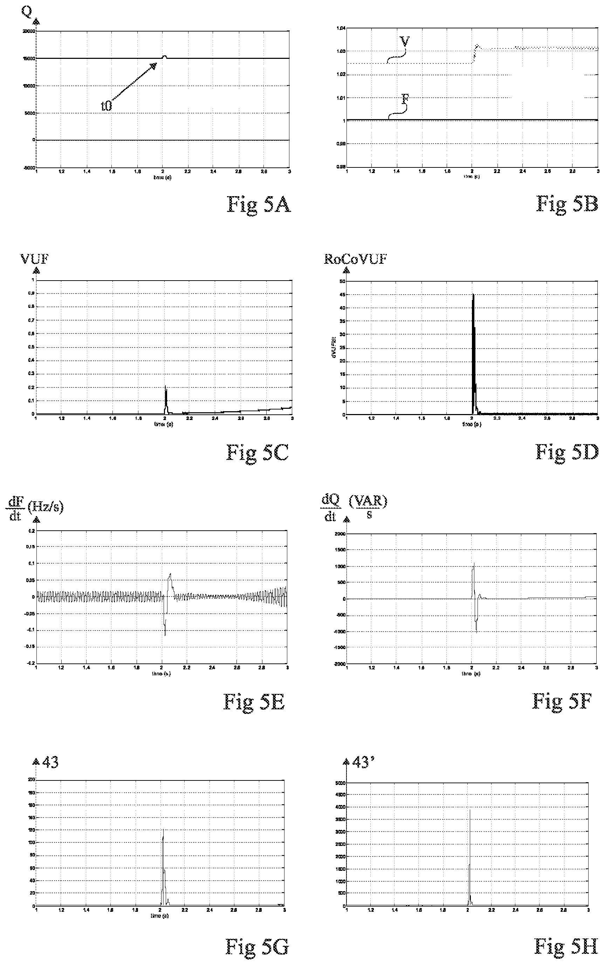

Les figures 5A, 5B, 5C, 5D, 5E, 5F, 5G et 5H sont des chronogrammes illustrant le fonctionnement des modes de réalisation des figures 3 et 4.

La figure 5A illustre la variation de la puissance réactive de l'onduleur 22. On suppose un instant d'îlotage t0 à environ 2 secondes sur l'exemple temporel pris dans ces figures.

La figure 5B illustre, à une échelle normalisée, les variations de tension V et de la fréquence F.

La figure 5C illustre la dérivée du taux (en pourcents) de déséquilibre de tension VUF.

La figure 5D illustre la dérivée RoCoVUF du taux de déséquilibre de tension.

La figure 5E illustre la dérivée RoCoF de la fréquence (en Hz/s).

La figure 5F illustre la dérivée RoCoQ de la puissance réactive (en VAR/s).

La figure 5G illustre le résultat fourni par le multiplieur 43 de la figure 3, c'est-à-dire la valeur RoCoVUF pondérée par la valeur RoCoF.

La figure 5H illustre le résultat fourni par le multiplieur 43' de la figure 4, c'est-à-dire le résultat précédent pondéré par la valeur RoCoQ.

Comme l'illustrent les figures 5G et 5H, la pondération provoque un phénomène d'amplification de l'effet de détection d'îlotage et fait que, si un de ces facteurs est proche de 0, cela signifie une absence d'îlotage et le produit reste également proche de 0.

Dans l'exemple ci-dessus, les seuils TH et TH' peuvent être fixés à des valeurs de l'ordre de 100 et 3000 respectivement et on voit que les résultats fournis sont quasiment nuls avant l'îlotage, ce qui montre une fiabilité contre des déclenchements intempestifs.

Un avantage des solutions proposées est, qu'étant passives, elles n'apportent pas de perturbation au réseau 3.

Un autre avantage est que l'efficacité de la détection n'est pas affectée si plusieurs onduleurs sont connectés en parallèle (présence de plusieurs microcentrales connectées au réseau).

Un autre avantage est que la mise en oeuvre des solutions décrites ne nécessite par de modifier l'onduleur. On peut donc aisément adapter des installations existantes.

Divers modes de réalisation ont été décrits. Diverses variantes et modifications apparaîtront à l'homme de l'art. En particulier, la mise en oeuvre pratique des modes de réalisation qui ont été décrits est à la portée de l'homme du métier à partir des indications fonctionnelles données ci-dessus et en utilisant des techniques habituelles de mesure de variation de tension, de charge réactive et de fréquence. De plus, la fréquence de prise en compte des mesures et de réaction du système dépend de la puissance de calcul disponible dans le circuit 4. En outre, bien que l'invention ait été plus particulièrement décrite en relation avec un exemple de centrale photovoltaïque, elle s'applique plus généralement à toute unité ou système susceptible de se trouver dans une situation d'îlotage par rapport à un réseau triphasé, par exemple une batterie associée à un onduleur, une turbine, etc.

**Revendications**

1. Procédé de détection d'îlotage d'un onduleur (22) connecté à un réseau de distribution électrique (3), **caractérisé en ce que** le procédé comporte comportant au moins des étapes de :

   détermination de la dérivée temporelle du taux de déséquilibre de tension entre phases (RoCoVUF) fournie par l'onduleur ;
   détermination de la dérivée temporelle de la fréquence (RoCoF) de la tension fournie par l'onduleur ;
   multiplication (43 ; 43') des deux valeurs ; et
   comparaison (46) à un seuil (TH ; TH').

2. Procédé selon la revendication 1, comportant en outre des étapes de :

   détermination de la dérivée temporelle de la charge réactive (RoCoQ) de l'onduleur ; et
   prise en compte de cette valeur dans l'étape de multiplication (43).

3. Procédé selon la revendication 1 ou 2, dans lequel l'onduleur (22) fournit une tension triphasée.

**4.** Procédé selon l'une quelconque des revendications 1 à 3, comportant en outre une étape de fourniture d'un signal de commande à l'onduleur (22).

**5.** Procédé selon l'une quelconque des revendications 1 à 4, dans lequel l'onduleur (22) est associé à des panneaux photovoltaïques (2).

**6.** Dispositif (4) de détection d'îlotage adapté à la mise en oeuvre du procédé conforme à l'une quelconque des revendications précédentes.

**7.** Dispositif selon la revendication 6, comportant au moins un capteur de tension connecté en sortie de l'onduleur (22).

**8.** Dispositif selon la revendication 6 ou 7, comportant en outre un capteur de charge réactive.

**9.** Dispositif selon l'une quelconque des revendications 6 à 8, comportant des moyens de calcul desdites dérivées.

**10.** Centrale solaire comportant :

    au moins un panneau photovoltaïque ;
    au moins un onduleur (22) ; et
    un dispositif conforme à l'une quelconque des revendications 6 à 9.

**Patentansprüche**

**1.** Verfahren zum Detektieren eines Lastabwurfs eines Inverters (22), der mit einem elektrischen Netz (3) verbunden ist, **dadurch gekennzeichnet, dass** das Verfahren zumindest folgende Schritte aufweist:

    Bestimmen der zeitlichen Ableitung des Spannungsasymmetriefaktors zwischen Phasen (RoCoVUF), die von dem Inverter ausgegeben werden;
    Bestimmen der zeitlichen Ableitung der Frequenz (RoCoF) der Spannung, die von dem Inverter ausgegeben wird;
    Multiplizieren (43; 43') der zwei Werte; und
    Vergleichen (46) des Ergebnisses mit einer Schwelle (TH; TH').

**2.** Verfahren nach Anspruch 1, weiches weiter folgende Schritte aufweist:

    Bestimmen der zeitlichen Ableitung der Blindlast (RoCoQ) des Inverters; und
    Berücksichtigen dieses Wertes beim Multiplikationsschritt (43).

**3.** Verfahren nach Anspruch 1 oder 2, wobei der Inverter (22) eine dreiphasige Spannung ausgibt.

**4.** Verfahren nach einem der Ansprüche 1 bis 3, welches weiter einen Schritt aufweist, ein Steuersignal an den Inverter (22) zu liefern.

**5.** Verfahren nach einem der Ansprüche 1 bis 4, wobei der Inverter (22) mit Photovoltaik-Paneelen (2) assoziiert ist.

**6.** Lastabwurfdetektionsvorrichtung (4), welche das Verfahren nach einem der vorangehenden Ansprüche ausführen kann.

**7.** Vorrichtung nach Anspruch 6, die zumindest einen Spannungssensor aufweist, der mit dem Ausgang des Inverters (22) verbunden ist.

**8.** Vorrichtung nach Anspruch 6 oder 7, die weiter einen Blindlastsensor aufweist.

**9.** Vorrichtung nach einem der Ansprüche 6 bis 8, die Mittel aufweist, um die Ableitungen zu berechnen.

**10.** Solarleistungserzeugungsvorrichtung, die Folgendes aufweist:

    zumindest ein Photovoltaik-Paneel;
    zumindest einen Inverter (22); und
    die Vorrichtung nach einem der Ansprüche 6 bis 9.

**Claims**

**1.** A method of detecting the load shedding of an inverter (22) connected to an electricity mains (3), **characterized in that** the method comprises at least steps of:

    determining the time derivative of the voltage unbalance factor between phases (RoCoVUF) output by the inverter;
    determining the time derivative of the frequency (RoCoF) of the voltage output by the inverter;
    multiplying (43; 43') the two values; and
    comparing (46) the result with a threshold (TH; TH').

**2.** The method of claim 1, further comprising steps of :

    determining the time derivative of the reactive load (RoCoQ) of the inverter; and
    taking into account this value in the multiplication step (43).

**3.** The method of claim 1 or 2, wherein the inverter (22) outputs a three-phase voltage.

4. The method of any of claims 1 to 3, further comprising a step of supplying a control signal to the inverter (22).

5. The method of any of claims 1 to 4, wherein the inverter (22) is associated with photovoltaic panels (2).

6. A load shedding detection device (4), capable of implementing the method of any of the foregoing claims.

7. The device of claim 6, comprising at least one voltage sensor connected to the output of the inverter (22).

8. The device of claim 6 or 7, further comprising a reactive load sensor.

9. The device of any of claims 6 to 8, comprising means for calculating said derivatives.

10. A solar power plant comprising:

   at least one photovoltaic panel;
   at least one inverter (22); and
   the device of any of claims 6 to 9.

Fig 1

Fig 2

Fig 3

Fig 4

Fig 5A

Fig 5B

Fig 5C

Fig 5D

Fig 5E

Fig 5F

Fig 5G

Fig 5H